# EUROPEAN PATENT APPLICATION

(11) **EP 4 245 882 A1**
(43) Date of publication of application: **20.09.2023**
(21) Application number: 21891602.1
(22) Date of filing: 19.10.2021
(51) Int. Cl.: C23C 14/24

(54) **FILM FORMATION DEVICE**

(30) Priority: 13.11.2020 JP 2020189364
(71) Applicant: Shincron Co., Ltd., Kanagawa 220-8680 (JP)
(72) Inventor: IGARASHI, Makoto, Yokohama-shi, Kanagawa 220-8680 (JP); SAITO, Suguru, Yokohama-shi, Kanagawa 220-8680 (JP); NONAKA, Yuya, Yokohama-shi, Kanagawa 220-8680 (JP)
(74) Representative: Ter Meer Steinmeister & Partner
(86) International application number: PCT/JP2021/038582
(87) International publication number: WO 2022/102355

(57) **Abstract**

A film formation device having a high operation rate is provided. The film formation device includes: a film formation chamber (2) in which at least a film formation material (M) and a film formation target (S) are provided, wherein the film formation chamber (2) can be set to a predetermined film formation atmosphere; a hearth liner (23) provided inside the film formation chamber (2) to accommodate the film formation material (M); a heating source (24) provided inside the film formation chamber (2) to heat the film formation material (M) accommodated in the hearth liner (23); and a material supply chamber (3) having a material-filled unit (35) that is filled with the film formation material (M) to supply to the hearth liner (23). The material supply chamber (3) is connected to the film formation chamber (2) via a communication path (36) having a gate valve (37) and can be set to a predetermined pressure atmosphere. When the film formation material (M) is supplied, after the inside of the material supply chamber (3) is set to the predetermined pressure atmosphere in a state in which the film formation chamber (2) is set to the film formation atmosphere, the gate valve (37) is opened to supply the film formation material (M), which fills the material-filled unit (35), to the hearth liner (23) via the communication path (36).

## Description

### [Technical Field]

The present invention relates to a film formation device and more particularly to a film formation device to which a vacuum vapor deposition method is preferably applied.

### [Background Art]

A film formation device using a vacuum deposition method is known. The film formation device is provided with a plurality of hearth blocks (hearths, crucibles, also referred to as hearth liners) that accommodate vapor deposition materials. The film formation device is configured to form a composite multilayer film through accommodating different types of vapor deposition materials in the hearth blocks and evaporating the different types of vapor deposition materials from a film formation source while switching the hearth blocks in the same batch (Patent Document 1).

### [Prior Art Document]

### [Patent Document]

[Patent Document 1] JP6715739B

### [Summary of Invention]

### [Problems to be solved by Invention]

Meanwhile, even when a plurality of hearth blocks are provided as in the above-described conventional film formation device, there is a limit to how much the vapor deposition materials can be accommodated. Thus, when replenishing the vapor deposition materials, the inside of the vapor deposition chamber has to be returned to the ambient atmosphere, and the film formation process cannot be continued while maintaining the vacuum atmosphere; therefore, there is a problem in that the operation rate of the film formation device is low because the film formation process is interrupted.

A problem to be solved by the present invention is to provide a film formation device having a high operation rate.

### [Means for solving problems]

The present invention solves the above problem by providing a material supply chamber having a material-filled unit that is filled with a film formation material to supply to a hearth liner, wherein the material supply chamber is connected to a film formation chamber via a communication path having a gate valve and can be set to a predetermined pressure atmosphere.

### [Effect of Invention]

According to the present invention, after the inside of the material supply chamber is set to the predetermined pressure atmosphere in a state in which the film formation chamber is set to the film formation atmosphere, the gate valve is opened to supply the film formation material, which fills the material-filled unit, to the hearth liner via the communication path. As a result, it is not necessary to return the film formation chamber to the ambient pressure atmosphere, and the operation rate of the film formation device can therefore be increased.

### [Brief Description of Drawings]

FIG. 1 is a block diagram including a vertical cross-sectional view of a main portion illustrating an embodiment of a film formation device according to the present invention.
FIG. 2 is a plan view of the film formation device of FIG. 1.
FIG. 3 is an enlarged cross-sectional view of a hearth holder and a hearth liner of FIG. 1.
FIG. 4 is a block diagram including a vertical cross-sectional view illustrating an enlarged main portion including a weight measuring instrument of FIG. 1.
FIG. 5 is a block diagram including a vertical cross-sectional view illustrating an enlarged main portion including a cooler of FIG. 1.
FIG. 6 is a flow chart illustrating a main process executed by a control unit of FIG. 1.
FIG. 7 is a flow chart illustrating a subroutine of step S5 of FIG. 1.

### [Mode(s) for Carrying out the Invention]

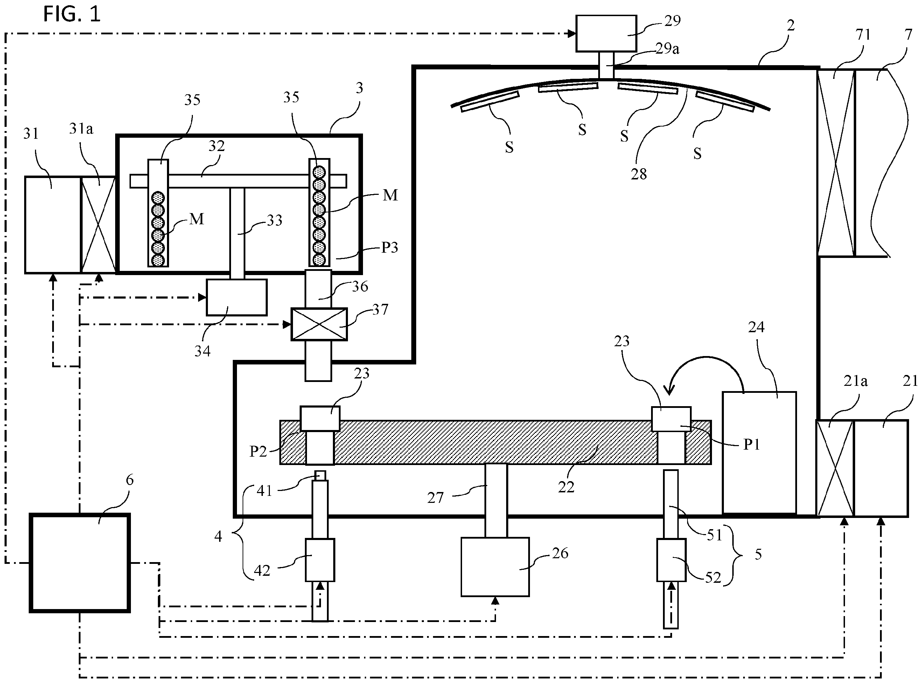

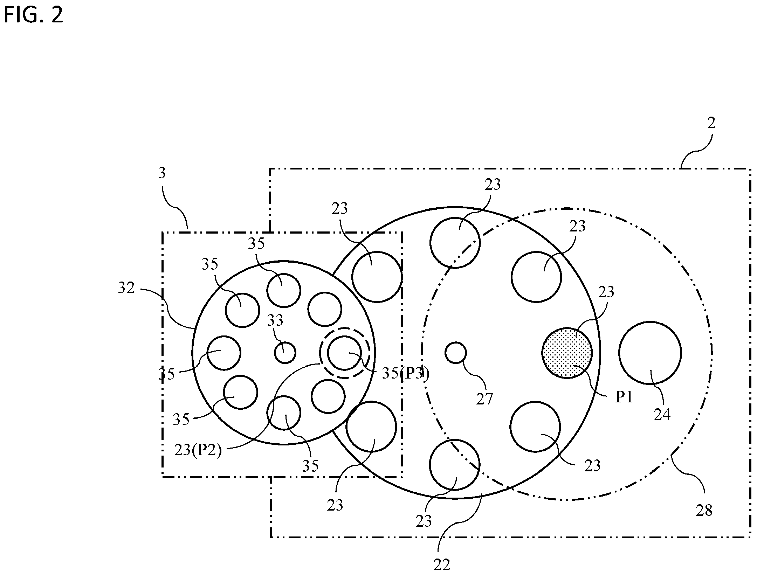

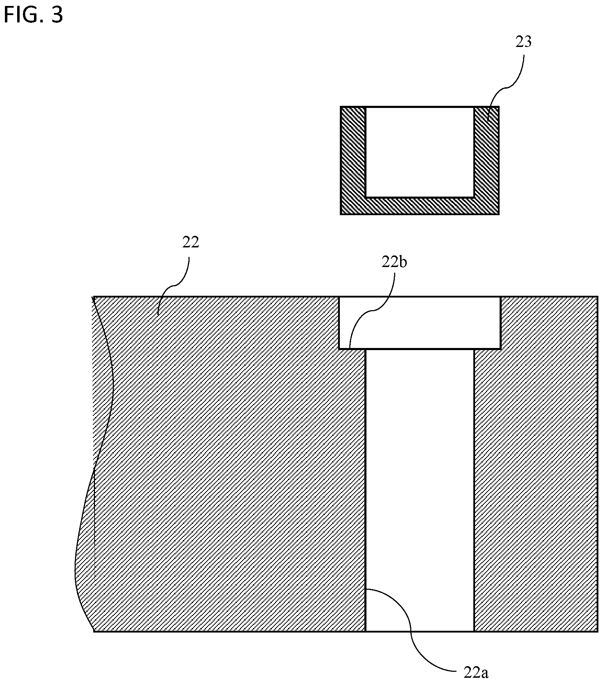

An embodiment of the film formation device according to the present invention will be described below with reference to the drawings. FIG. 1 is a block diagram including a vertical cross-sectional view of the main portion illustrating an embodiment of a film formation device 1 according to the present invention, FIG. 2 is a plan view of the same, and FIG. 3 is an enlarged cross-sectional view illustrating a hearth holder and a hearth liner. The film formation device of the present invention can typically be embodied as a vacuum vapor deposition device, and the film formation device 1 using a vacuum vapor deposition method will therefore be described below as an embodiment of the present invention. It is, however, not intended that the film formation device of the present invention is limited only to a vacuum vapor deposition device using a vacuum vapor deposition method, and the film formation device of the present invention represents those in a broad sense including film formation devices other than the vacuum vapor deposition device.

The film formation device 1 of the present embodiment is provided with at least a film formation material M and a film formation target S and includes a film formation chamber 2 that can be set to a predetermined film formation atmosphere and a material supply chamber 3 that is connected to the film formation chamber 2 and can be set to a predetermined pressure atmosphere.

The film formation chamber 2 is provided with an evacuation device 21 via a gate valve 21a. By opening the gate valve 21a to evacuate the gas inside the film formation chamber 2, the inside of the film formation chamber 2 can be set, for example, to a vacuum atmosphere suitable for a vapor deposition process. As the degree of vacuum increases inside the film formation chamber 2, the mean free path of the film formation material M increases, and the evaporation temperature of the film formation material decreases, thus promoting the vapor deposition process. The evacuation device 21 and the gate valve 21a are controlled by command signals from a controller 6.

The film formation chamber 2 is provided with a film formation target holder 28 that supports film formation targets S such as semiconductor wafers, glass substrates, or plastic substrates. The film formation target holder 28 is suspended from the ceiling of the film formation chamber 2. Although not particularly limited, the film formation target holder 28 of the present embodiment is composed of a plate-like member that has a concaved spherical surface so that distances between the film formation targets S and a hearth liner 23 in which the film formation material M evaporates are as uniform as possible. Also although not particularly limited, the film formation target holder 28 of the present embodiment is configured to be rotatable by a holder drive unit 29 composed of a motor and the like, and this configuration also contributes to an approximately uniform thickness of the films formed on respective film formation targets S. The holder drive unit 29 is controlled by a command signal from the controller 6.

The film formation chamber 2 is provided with a load lock chamber (preliminary vacuum chamber) 7, which is connected to the film formation chamber 2 via a gate valve 71. The inside of the load lock chamber 7 can also be set to the same vacuum atmosphere as the film formation chamber 2 by an evacuation device (not illustrated) provided in the load lock chamber 7. The load lock chamber 7 is provided with a door (not illustrated), and access to the outside of the film formation device 1, which is in the ambient pressure atmosphere, can be performed through the door.

The film formation target holder 28 is detachably attached to a rotation shaft 29a or the like of the holder drive unit 29. When performing the film formation process, a robot (not illustrated) or the like is used to grip the film formation target holder 28 loaded with a plurality of film formation targets S before film formation, and the film formation target holder 28 is carried into the film formation chamber 2 from the load lock chamber 7 and attached to the rotation shaft 29a of the holder drive unit 29. After the film formation process is completed, the load lock chamber 7 is set to the same vacuum atmosphere as the film formation chamber 2, and then the gate valve 71 is opened. In this state, a robot (not illustrated) or the like is used to grip the film formation target holder 28 loaded with the film formation targets S after film formation, and the film formation target holder 28 is carried out from the film formation chamber 2 to the load lock chamber 7. Thus, by providing the load lock chamber 7, it is possible to carry the film formation targets S into or out of the film formation chamber 2 while maintaining the vacuum atmosphere of the film formation chamber 2.

The film formation chamber 2 is provided with a hearth holder 22 that is supported on the floor surface inside the film formation chamber 2 so as to be rotatable around a shaft 27. The hearth holder 22 is capable of stepping rotation at a predetermined rotation angle around the shaft 27 by a first drive unit 26 and a rotary encoder (not illustrated). The first drive unit 26 is composed of a motor and the like.

Although not particularly limited, the hearth holder 22 supports eight hearth liners 23 concentrically, as illustrated in FIGS. 1 and 2. Also although not particularly limited, the eight hearth liners 23 are provided at equal angles in the circumferential direction with respect to the shaft 27. As illustrated in FIG. 3, supporting portions of the hearth holder 22 that support the eight hearth liners 23 are each formed with a through hole 22a having a diameter that allows a weight measuring instrument 4 and a cooler 5 to be inserted into the through hole 22. The upper end of the through hole 22 is formed with a seating surface 22b whose diameter is larger than that of the through hole 22 and slightly larger than the outer diameter of each hearth liner 23 accommodating the film formation material. The hearth liner 23 is placed on the seating surface 22b in a separable manner (i.e., in an attachable and detachable manner).

The shapes including the outer diameters of the hearth liners 23 supported by the hearth holder 22 may all be the same shape or may also be different shapes. When using the hearth liners 23 all having the same shape, the dimensions such as the inner diameters of the seating surfaces 22b formed on the hearth holder 22 may all be the same dimensions. When using the hearth liners 23 having different shapes, the seating surfaces 22b of the hearth holder 22 may have dimensions corresponding to the shapes of respective hearth liners 23.

Film formation materials M to be fed into the eight hearth liners 23 may all be of the same type, or different types of film formation materials M may also be fed. Alternatively, less than eight types of film formation materials M may be distributed to the eight hearth liners 23.

Each hearth liner 23 is a so-called crucible of melting furnace into which the film formation material M is fed to be heated and melted, and is also called a hearth block or simply a hearth. Although not particularly limited, the hearth liner 23 of the present embodiment is formed by coating a main body made, for example, of insulating pyrolytic boron nitride (PBN) with a conductive film, and the main body of PBN can be manufactured by a pyrolysis method using CVD. Alternatively, the hearth liner 23 may be composed of molybdenum or tungsten. When the surface of the film formation material M accommodated in the hearth liner 23 is irradiated with an electron beam from an electron gun that is a heating source 24 and electrons are introduced, a current flows through the conductive film of the PBN hearth liner 23 to the hearth liner 23, and the PBN hearth liner 23 itself becomes red-hot and reaches a temperature at which the accommodated film formation material M can evaporate. On the other hand, the hearth holder 22 is made of copper, although not particularly limited.

The heating source 24, which is provided inside the film formation chamber 2, heats and evaporates the film formation material M accommodated in the hearth liner 23. For the heating source 24, electron beam heating using an electron gun as well as resistance heating, high frequency induction heating, and laser beam heating can be used. The heating source 24 of the film formation device 1 of the embodiment illustrated in FIG. 1 adopts electron beam heating using an electron gun, and one hearth liner 23 located at the closest position (also referred to as an evaporation position P1, hereinafter) indicated by hatching in FIG. 2 is irradiated with the electron beam.

The material supply chamber 3 is provided with an evacuation device 31 via a gate valve 31a. The inside of the material supply chamber 3 can be set, for example, to the same vacuum atmosphere as the inside of the film formation chamber 2 by opening the gate valve 31a to evacuate the gas inside the material supply chamber 3. By setting the inside of the material supply chamber 3 to the same vacuum atmosphere as the inside of the film formation chamber 2, the film formation material M can be replenished while maintaining the vacuum atmosphere inside the film formation chamber 2. The evacuation device 31 and the gate valve 31a are controlled by command signals from the controller 6.

The material supply chamber 3 is provided with a magazine holder 32 that is supported on the floor surface inside the material supply chamber 3 so as to be rotatable around a rotation shaft 33. The magazine holder 32 is capable of stepping rotation at a predetermined rotation angle around the rotation shaft 33 by a second drive unit 34 and a rotary encoder (not illustrated). The second drive unit 34 is composed of a motor and the like. The second drive unit 34 is controlled by a command signal from the controller 6.

Although not particularly limited, the magazine holder 32 supports eight magazines 35 concentrically, as illustrated in FIGS. 1 and 2. Also although not particularly limited, the eight magazines 35 are provided at equal angles in the circumferential direction with respect to the rotation shaft 33. Each magazine 35 corresponds to the material-filled unit of the present invention. The magazine 35 is composed, for example, of a tubular body having an opening at the ceiling and an opening/closing door at the bottom. The film formation material M in a granular shape is fed into the magazine 35 from its opening at the ceiling, and the opening/closing door at the bottom is opened thereby to drop the granular film formation material M in the magazine 35 into a communication path 36. The opening/closing door of the magazine 35 may be a mechanical mechanism configured to automatically open when the magazine 35 reaches a replenishment position P3 and automatically close when the magazine 35 is located at a position other than the replenishment position P3, or an actuator may otherwise be provided to open/close the opening/closing door by electrical control.

The eight magazines 35 may accommodate film formation materials M having the same weight or may also accommodate film formation materials M having different weights. Alternatively, the film formation materials M may be accommodated in different weight classifications such as large, medium, and small. The film formation materials M accommodated in the eight magazines 35 may all be of the same type, or different types of film formation materials M may also be fed. Alternatively, less than eight types of film formation materials M may be distributed to the eight magazines 35.

The communication path 36 having a gate valve 37 is provided between the material supply chamber 3 and the film formation chamber 2, which can thereby be spatially communicated with each other or isolated from each other. The upper end of the communication path 36 is provided to match the replenishment position P3 of the magazine 35 in charge while the lower end of the communication path 36 is provided to match a replenishment position P2 of the hearth liner 23 in charge. In FIG. 2, the communication path 36 is a straight pipe conduit because the replenishment position P3 of the magazine 35 and the replenishment position P2 of the hearth liner 23 overlap in the vertical direction. However, if the replenishment position P3 of the magazine 35 and the replenishment position P2 of the hearth liner 23 do not overlap in the vertical direction and are shifted from each other, the communication path 36 may be a curved pipe conduit. The gate valve 37 is controlled by a command signal from the controller 6.

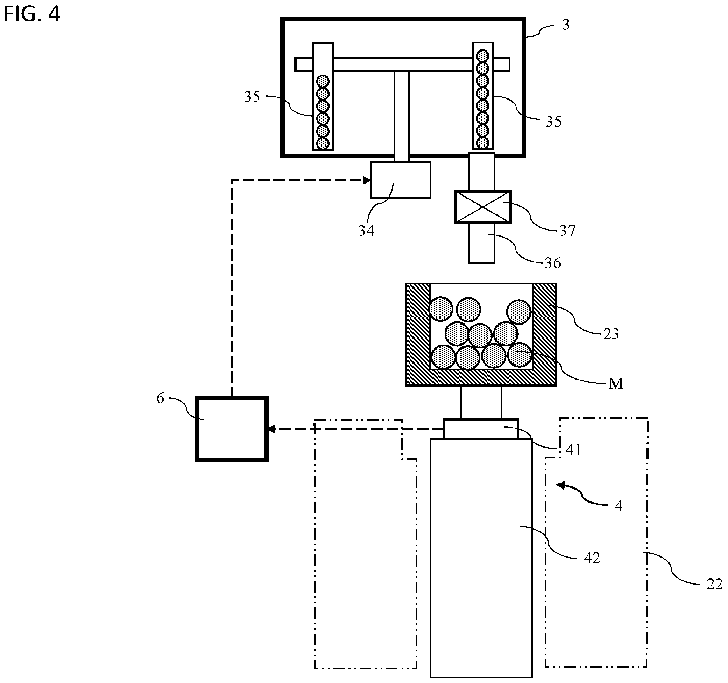

The film formation device 1 of the present embodiment further includes a weight measuring instrument 4 that measures the weight of the film formation material M supplied from the material supply chamber 3 to the hearth liner 23 in charge. FIG. 4 is a block diagram including a vertical cross-sectional view illustrating an enlarged main portion of the film formation device 1 including the weight measuring instrument 4. The weight measuring instrument 4 of the present embodiment is provided below the replenishment position P2 of the hearth holder 22. The weight measuring instrument 4 measures the weight of the film formation material M supplied to the hearth liner 23 located at the replenishment position P2 in a state in which the inside of the film formation chamber 2 is set to the film formation atmosphere.

Conventionally, the weight of the film formation material M before replenishment may be measured and used as the replenishment amount for the hearth liner 23. In contrast, the weight measuring instrument 4 of the present embodiment measures the weight of the film formation material M supplied to the hearth liner 23 located at the replenishment position P2; therefore, the material springing and spilled during the replenishment can be excluded from the measurement value and it is possible to accurately measure the weight itself of the film formation material M actually replenished to the hearth liner 23. Also conventionally, the replenishment may be performed based on the number of grains of the granular film formation material M. By contrast, in the present embodiment, the weight itself of the film formation material M is measured; therefore, even if there are manufacturing variations in the weight of the grains, it is possible to accurately measure the weight of the film formation material M actually replenished to the hearth liner 23.

The weight measuring instrument 4 of the present embodiment includes a measurement unit 41 and a measurement unit elevating mechanism 42 that has a tip portion on which the measurement unit 41 is provided. The measurement unit elevating mechanism 42 moves up and down in the through hole 22a of the hearth holder 22, which is located at the replenishment position P2, by means of a ball screw mechanism or the like. When moving up, the measurement unit elevating mechanism 42 raises the hearth liner 23 supported by the hearth holder 22. This allows the hearth liner 23 to be separated from the hearth holder 22. When the measurement unit elevating mechanism 42 moves down from this state, the separated hearth liner 23 also moves down and is supported again by the hearth holder 22.

The measurement unit 41 provided at the tip portion of the measurement unit elevating mechanism 42 is composed, for example, of a load cell and measures the weight of the hearth liner 23 in a state in which, as illustrated in FIG. 4, the hearth liner is lifted and separated from the hearth holder 22. The measurement unit elevating mechanism 42 is controlled by a command signal from the controller 6, and the detection signal of the measurement unit 41 is output to the controller 6.

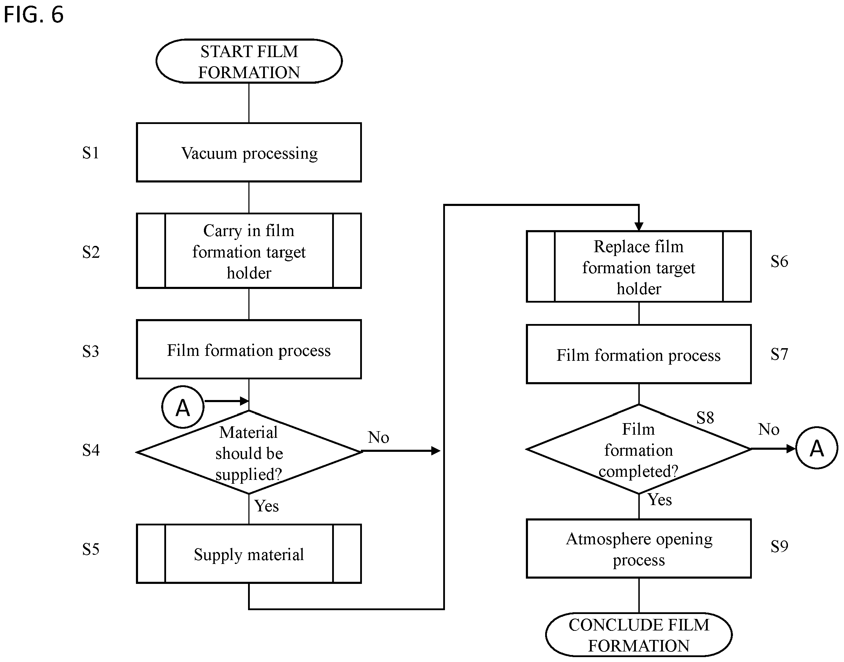

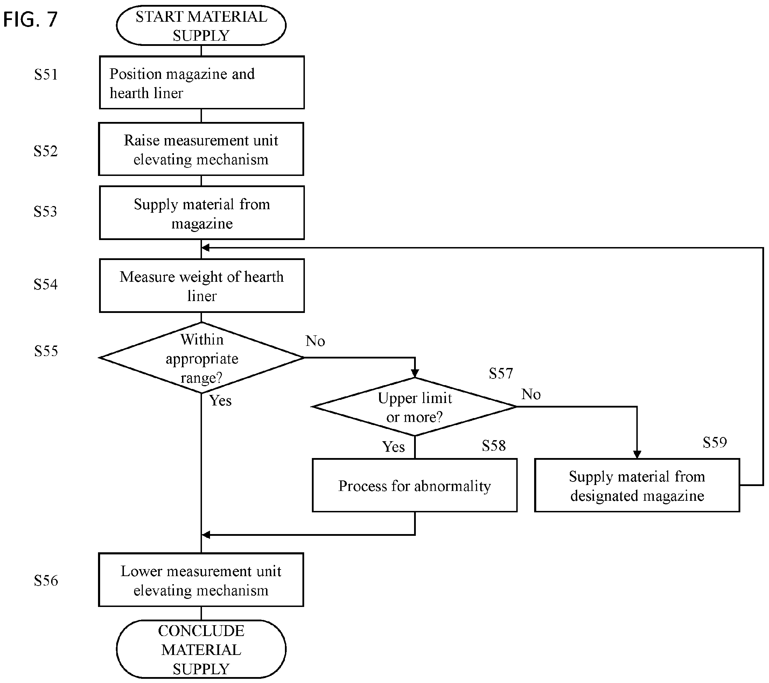

The description will now be made for a procedure of supplying a specific film formation material M to a specific hearth liner 23 while maintaining the vacuum atmosphere of the film formation chamber 2. FIG. 7 is a flow chart illustrating a step of material supply (step S5 of FIG. 6).

To fill the magazines 35 of the material supply chamber 3 with the film formation materials M, the inside of the material supply chamber 3 is returned to the ambient pressure atmosphere, and then the film formation materials M are fed into respective magazines 35 from a door (not illustrated) provided in the material supply chamber 3. Then, to supply a certain film formation material M from a magazine 35 of the material supply chamber 3 to a hearth liner 23 of the film formation chamber 2, first, the inside of the material supply chamber 3 is set to the same vacuum atmosphere as the inside of the film formation chamber 2. In tandem with this, the controller 6 specifies the position of the magazine 35 filled with the film formation material M to supply and outputs a command signal to the second drive unit 34 to move the magazine 35 to the replenishment position P3. The controller 6 also specifies the position of the hearth liner 23 to be supplied with the film formation material M and outputs a command signal to the first drive unit 26 to move the hearth liner 23 to the replenishment position P2. Through this operation, the magazine 35 filled with the film formation material M to supply and the hearth liner 23 to be supplied with the film formation material M are positioned at the replenishment positions P3 and P2, respectively, above and below the communication path 36. The above is the processing of step S51.

After the positioning of the magazine 35 and the hearth liner 23 is completed, the measurement unit elevating mechanism 42 is raised to lift the hearth liner 23 at the replenishment position P2 and separate it from the hearth holder 22 (step S52). By reading the output signal from the measurement unit 41 in this state, it is possible to measure a weight W₁ of the hearth liner 23 before supplying the film formation material M. When the film formation material M is newly supplied to the hearth liner 23, the weight W₁ of the hearth liner 23 before supplying the film formation material M represents a weight W₀ of the hearth liner 23 alone. When the film formation material M is added, the weight W₁ of the hearth liner 23 before supplying the film formation material M represents the sum of the weight W₀ of the hearth liner 23 alone and the weight of the remaining film formation material M. In any case, the controller 6 which reads the weight W₁ of the hearth liner 23 before supplying the film formation material M can calculate the weight of the film formation material M that can be supplied to the hearth liner 23.

Then, the gate valve 37 is opened, and the opening/closing door on the bottom surface of the magazine 35 is opened to supply the film formation material M to the hearth liner 23 (step S53). By reading the output signal from the measurement unit 41 in this state, it is possible to measure a weight W₂ of the hearth liner 23 after supplying the film formation material M. Here, the controller 6 calculates the weight of the supplied film formation material M alone. For example, when the film formation material M is newly supplied, a value (W₂-W₀) is obtained by subtracting the weight W₀ of the hearth liner 23 alone from a measured weight W₂. When the film formation material M is added, the value (W₂-W₁) is obtained by subtracting the sum of the weight W₀ of the hearth liner 23 alone and the weight of the remaining film formation material M from the measured weight W₂. The above is the processing of step S54.

Then, the controller 6 determines whether the result of weight measurement in step S54 satisfies a target supply weight range (step S55). The target supply weight range means a range of the weight suitable for supplying to the hearth liner 23 and may be represented by any of only an upper limit, only a lower limit, or an upper limit and a lower limit. However, if the target supply weight range is represented only by the lower limit, there is a risk that an excessive amount of the film formation material M will be supplied to the hearth liner 23 and will overflow from the hearth liner 23. On the other hand, if the target supply weight range is represented only by the upper limit, only an insufficient amount of the film formation material M will be supplied to the hearth liner 23, and a sufficient film thickness may not be obtained. It is therefore preferred to set the target supply weight within a range having an upper limit and a lower limit.

In step S55, when the result of weight measurement in step S54 falls within the target supply weight range, the process proceeds to step S56 in which the measurement unit elevating mechanism 42 is lowered, the hearth liner 23 lifted until then is placed on the hearth holder 22 again, and the material supply process is concluded.

On the other hand, in step S55, when the result of weight measurement in step S54 falls outside the target supply weight range, the process proceeds to step S57 to determine whether or not the target supply weight is equal to or higher than the upper limit. In step S57, when the result of weight measurement in step S54 is equal to or higher than the upper limit of the target supply weight range, the process proceeds to step S58 to perform a process for abnormality, followed by step 56 in which the measurement unit elevating mechanism 42 is lowered, the hearth liner 23 lifted until then is placed on the hearth holder 22 again, and the material supply process is concluded. The process for abnormality in step S58 includes stopping the material supply thereafter and alerting the operator that there is an abnormality, such as issuing a warning to the operator. This is because if the result of weight measurement for the hearth liner 23 is equal to or higher than the upper limit of the target supply weight range, there is a possibility that the supplied film formation material M overflows or the hearth liner 23 adheres to the hearth holder 22 due to the film formation material M which has overflowed during the previous evaporation process.

On the other hand, in step S57, when the result of weight measurement is not equal to or higher than the upper limit of the target supply weight range, that is, when the result of weight measurement is equal to or lower than the lower limit of the target supply weight range, the process proceeds to step S59 to supply the film formation material M from the designated magazine 35. When the result of weight measurement is equal to or lower than the lower limit of the target supply weight range, the controller 6 calculates the weight of the film formation material M that is lacking, extracts the magazine 35 filled with the film formation material M having the corresponding weight, and controls the second drive unit 34 to move that magazine 35 to the replenishment position P3. Then, after opening the opening/closing door on the bottom surface of the magazine 35 to supply the film formation material M to the hearth liner 23, the process returns to step S54 to measure the weight of the hearth liner 23 again. For the second and subsequent measurements, the weights measured until then are added and compared with the target supply weight range.

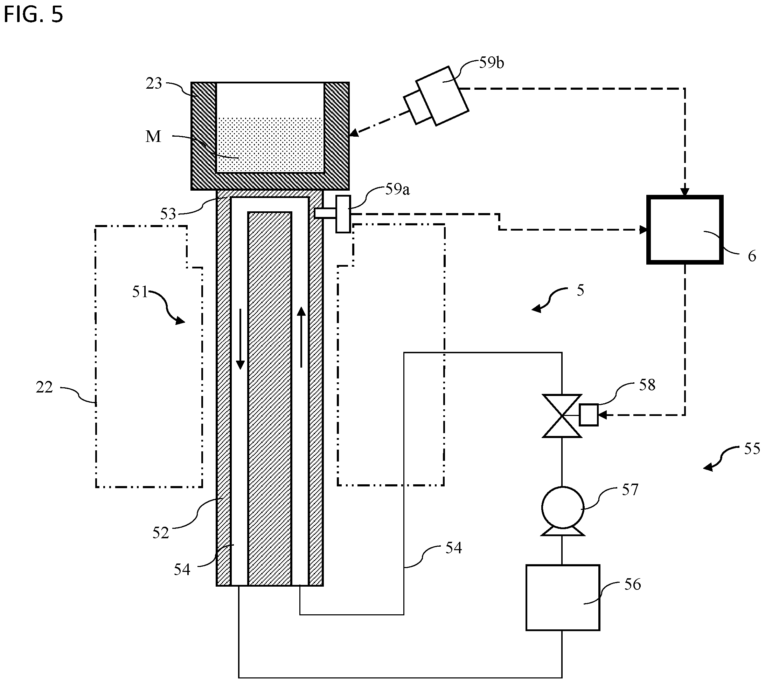

Referring again to FIG. 1, the film formation device 1 of the present embodiment further includes a cooler 5 that cools the hearth liner 23 at the evaporation position P1. This is because the hearth holder 22 and other peripheral components are overheated by the heating source 24. FIG. 5 is a block diagram including a vertical cross-sectional view illustrating an enlarged main portion of the film formation device 1 including the cooler 5. The cooler 5 of the present embodiment is provided below the evaporation position P1 of the hearth holder 22. In particular, the cooler 5 of the present embodiment cools the hearth liner 23 in a state in which the hearth liner 23 at the evaporation position P1 is lifted and separated from the hearth holder 22. This can eliminate the direct thermal contact between the hearth liner 23, which is heated, and the hearth holder 22 and other peripheral components, and it is possible to efficiently cool the hearth liner 23 while suppressing the overheating of the hearth holder 22 and other peripheral components because the vacuum atmosphere has high heat insulation (low thermal conductivity).

Conventionally, the crucible portion corresponding to the hearth liner 23 is in thermal contact with peripheral components, and the cooler therefore needs to cool not only the crucible portion but also those including the peripheral components. Thus, the structure of the cooler is complicated and large, and the cooling efficiency is low. In the film formation device 1 of the present embodiment, since the hearth liner 23 is cooled in a state in which the heated hearth liner 23 is separated from the hearth holder 22, the structure of the cooler can be simplified and downsized, and the cooling efficiency can be improved.

The cooler 5 of the present embodiment includes a cooler unit 51 and a cooler unit elevating mechanism 52. The cooler unit elevating mechanism 52 moves up and down in the through hole 22a of the hearth holder 22, which is located at the evaporation position P1, by means of a ball screw mechanism or the like. When moving up, the cooler unit elevating mechanism 52 comes into contact with the hearth liner 23 supported by the hearth holder 22 and raises the hearth liner 23. This allows the hearth liner 23 to be separated from the hearth holder 22. When the cooler unit elevating mechanism 52 moves down from this state, the separated hearth liner 23 also moves down and is supported again by the hearth holder 22.

As illustrated in FIG. 5, the tip portion of the cooler unit elevating mechanism 52 is provided with a cooling surface 53 of the cooler unit 51, and the cooling surface 53 comes into contact with the bottom surface of the hearth liner 23 to exchange heat. The cooler unit 51 includes a coolant flow path 54 whose part is provided inside the cooler unit elevating mechanism 52 and a coolant cooling mechanism 55 that cools the coolant. The coolant cooling mechanism 55 includes a chiller 56, a pump 57, and a flow control valve 58. As the coolant flowing through the coolant flow path 54, any of liquid coolant and gaseous coolant can be used, such as water, antifreeze, or oil. The coolant cooled by the chiller 56 is pressure-fed by the pump 57, the flow rate of the coolant is adjusted by the flow control valve 58, and then the coolant reaches the cooling surface 53 through the coolant flow path 54 inside the cooler unit elevating mechanism 52. On this cooling surface 53, the coolant draws heat from the hearth liner 23 to cool it and then returns to the chiller 56. The coolant flow path 54 is configured so as not to contact the hearth holder 22.

In the film formation device 1 of the present embodiment illustrated in FIG. 1, one hearth liner 23 is disposed at one evaporation position P1, so it is sufficient to provide one cooler 5 for cooling the hearth liner 23 at the evaporation position P1. However, if a plurality of evaporation positions Pn are provided inside one film formation chamber 2 and hearth liners 23 are disposed at respective evaporation positions Pn, coolers 5 having the cooling capacity required for the hearth liners 23 may be provided at corresponding evaporation positions Pn.

A temperature sensor 59a such as a thermocouple is provided on or in the vicinity of the cooling surface 53 at the tip portion of the cooler unit elevating mechanism 52, and the temperature sensor 59a detects the temperature of the cooling surface 53 or its vicinity and outputs it to the controller 6. Alternatively, a non-contact temperature sensor 59b may be provided to directly detect the temperature of the hearth liner 23 and output it to the controller 6. Although two temperature sensors 59a and 59b are illustrated in FIG. 5, either one of them may be provided.

The controller 6 of the present embodiment is preliminarily set with a reference temperature range for the temperature detected by the temperature sensor 59a or 59b and compares the temperature detected by the temperature sensor 59a or 59b with the reference temperature range. When the detected temperature is within the reference temperature range as a result of the comparison, the controller 6 determines that the setting of the cooling capacity of the cooler 5 is appropriate, and continues the film formation process. On the other hand, when the detected temperature is below the reference temperature range as a result of the comparison, the controller 6 reduces the cooling capacity of the cooler 5, while when the detected temperature is above the reference temperature range, the controller 6 increases the cooling capacity of the cooler 5. The cooling capacity of the cooler 5 is controlled by adjusting the degree of opening of the flow control valve 58. When the flow rate of the coolant flowing through the coolant flow path 54 is reduced, the cooling capacity is also reduced, while when the flow rate of the coolant is increased, the cooling capacity is also increased. The temperature of the vapor deposition material M increases as the output power value of the heating source 24 composed of an electron gun or the like increases; therefore, when the output power value of the heating source 24 is high, the cooling capacity of the cooler 5 may be relatively increased compared to when the output power value is low.

The description will then be made for the outline of a film formation process using the film formation device 1 of the present embodiment. FIG. 6 is a flow chart illustrating a main process executed by the controller 6 of the film formation device 1 of the present embodiment. First, when the film formation process is started, in step S1, the gate valve 21a of the film formation chamber 2 is opened and the evacuation device 21 is used to evacuate the inside of the film formation chamber 2 into a predetermined vacuum atmosphere.

Then, in step S2, a robot (not illustrated) or the like is used to grip the film formation target holder 28 loaded with a plurality of film formation targets S before film formation, and the film formation target holder 28 is carried into the load lock chamber 7. After that, the inside of the lock chamber 7 is set to the same vacuum atmosphere as the film formation chamber 2. Then, the gate valve 71 is opened, and after the film formation target holder 28 loaded with the plurality of film formation targets S before film formation is carried into the film formation chamber 2 from the load lock chamber 7 by using a robot or the like and is attached to the rotation shaft 29a of the holder drive unit 29, the gate valve 71 of the load lock chamber 7 is closed. The order of steps S1 and S2 at the start of film formation may be reversed.

Then, in step S3, the first drive unit 26 is driven to move the hearth liner 23, which accommodates the film formation material M to be vapor-deposited, to the evaporation position P1. Then, the heating source 24 is driven to heat the hearth liner 23 at the evaporation position P1 to evaporate the film formation material M while rotating the film formation target holder 28 at a predetermined constant speed by driving the holder drive unit 29. This allows the evaporated film formation material M to be vapor-deposited on the film formation targets S to form respective films.

After the vapor deposition films having a predetermined film thickness are formed on the plurality of film formation targets S loaded on the film formation target holder 28, the film formation process is concluded, followed by step S4 in which a determination is made whether or not the supply (replenishment) of the film formation material M is necessary. When the film formation process is performed continuously or when the type of the film formation material M is changed, the supply of the film formation material is necessary, so the process proceeds to step S5, in which the material supply described previously with reference to FIG. 7 is performed, followed by step S6. When the supply (replenishment) of the film formation material is unnecessary, the process proceeds to step S6.

In step S6, the load lock chamber 7 is set to the same vacuum atmosphere as the film formation chamber 2, and then the gate valve 71 is opened. In this state, a robot or the like is used to grip the film formation target holder 28 loaded with the plurality of film formation targets S completed with the film formation process, and the film formation target holder 28 is carried out from the film formation chamber 2 to the load lock chamber 7. After that, the gate valve 71 is closed, then the load lock chamber 7 is returned to the ambient pressure atmosphere, and the film formation target holder 28 loaded with the film formation targets S after film formation is carried out to the outside through a door (not illustrated). Then, the film formation target holder 28 loaded with the film formation targets S before film formation is carried into the load lock chamber 7 through the same door, and after the door is closed, the inside of the lock chamber 7 is set to the same vacuum atmosphere as the film formation chamber 2. When the inside of the load lock chamber 7 becomes the same vacuum atmosphere as the film formation chamber 2, the gate valve 71 of the load lock chamber 7 is opened, and after the film formation target holder 28 loaded with the plurality of film formation targets S before film formation is carried into the film formation chamber 2 from the load lock chamber 7 by using a robot or the like and is attached to the rotation shaft 29a of the holder drive unit 29, the gate valve 71 of the load lock chamber 7 is closed. Thus, replacement of the film formation target holder 28 in step S6 is completed.

In the subsequent step S7, after performing the film formation process in the same procedure as in step S3, a determination is made in step S8 as to whether or not the film formation process has been completed, and when continued, the process returns to step S4. In step S8, when a determination is made that the film formation process has been completed, the process proceeds to step S9, in which the inside of the film formation chamber 2 is returned to the ambient pressure atmosphere, and the film formation process is concluded.

As described above, according to the film formation device 1 of the present embodiment, the material supply chamber 3 which can be set to the vacuum atmosphere equivalent to that of the film formation chamber 2 is provided apart from the film formation chamber 2, and the film formation material M can therefore be supplied to the hearth liner 23 while maintaining the vacuum atmosphere inside the film formation chamber 2.

Moreover, according to the film formation device 1 of the present embodiment, the weight measuring instrument 4 which measures the weight of the film formation material M supplied to the hearth liner 23 is further provided, and the weight measuring instrument 4 measures the weight of the film formation material M supplied to the hearth liner 23 in a state in which the inside of the film formation chamber 2 is set to the film formation atmosphere. Accordingly, the material springing and spilled during the replenishment can be excluded from the measurement value and it is possible to accurately measure the weight itself of the film formation material M actually replenished to the hearth liner 23. In addition, the weight measuring instrument 4 of the present embodiment measures the weight itself of the film formation material M; therefore, even if there are manufacturing variations in the weight of the grains, it is possible to accurately measure the weight of the film formation material M actually replenished to the hearth liner 23.

Furthermore, according to the film formation device 1 of the present embodiment, the cooler 5 which cools the hearth liner 23 is further provided, and the hearth liner 23 is cooled in a state in which the hearth liner 23 at the evaporation position P1 is lifted and separated from the hearth holder 22. This can eliminate the direct thermal contact between the hearth liner 23, which is heated, and the hearth holder 22 and other peripheral components, and it is possible to efficiently cool the hearth liner 23 while suppressing the overheating of the hearth holder 22 and other peripheral components because the vacuum atmosphere has high heat insulation (low thermal conductivity).

### [Description of Reference Numerals]

- 1: Film formation device
- 2: Film formation chamber
21 Evacuation device
21a Gate valve
22 Hearth holder
23 Hearth liner
24 Heating source
26 First drive unit
27 Shaft
28 Film formation target holder
29 Holder drive unit
- 3: Material supply chamber
31 Evacuation device
31a Gate valve
32 Magazine holder
33 Rotation shaft
34 Second drive unit
35 Magazine (material-filled unit)
36 Communication path
37 Gate valve
- 4: Weight measuring instrument
41 Measurement unit
42 Measurement unit elevating mechanism
- 5: Cooler
51 Cooler unit
52 Cooler unit elevating mechanism
53 Cooling surface
54 Coolant flow path
55 Coolant cooling mechanism
56 Chiller
57 Pump
58 Flow control valve
59a, 59b Temperature sensor
- 6: Controller
- 7: Load lock chamber
71 Gate valve
- M: Film formation material
- S: Film formation target
- P1: Evaporation position
- P2: Replenishment position

## Claims

1. A film formation device comprising:
a film formation chamber in which at least a film formation material and a film formation target are provided, wherein the film formation chamber can be set to a predetermined film formation atmosphere;
a hearth liner provided inside the film formation chamber to accommodate the film formation material;
a heating source provided inside the film formation chamber to heat the film formation material accommodated in the hearth liner; and
a material supply chamber having a material-filled unit that is arranged above the hearth liner and filled with the film formation material in a granular shape to supply to the hearth liner, wherein the material supply chamber is connected to the film formation chamber via a communication path having a gate valve and can be set to a predetermined pressure atmosphere,
wherein the communication path has an upper end provided at a replenishment position of the material-filled unit and a lower end provided at a replenishment position of the hearth liner,
wherein after inside of the material supply chamber is set to the predetermined pressure atmosphere in a state in which the film formation chamber is set to the film formation atmosphere, the gate valve is opened to allow the granular film formation material filling the material-filled unit to pass through the communication path by the film formation material's own weight, and the film formation material is supplied to the hearth liner.

2. A film formation device comprising:
a film formation chamber in which at least a film formation material and a film formation target are provided, wherein the film formation chamber can be set to a predetermined film formation atmosphere;
a hearth liner provided inside the film formation chamber to accommodate the film formation material;
a heating source provided inside the film formation chamber to heat the film formation material accommodated in the hearth liner; and
a material supply chamber having a material-filled unit that is filled with the film formation material to supply to the hearth liner, wherein the material supply chamber is connected to the film formation chamber via a communication path having a gate valve and can be set to a predetermined pressure atmosphere,
wherein after inside of the material supply chamber is set to the predetermined pressure atmosphere in a state in which the film formation chamber is set to the film formation atmosphere, the gate valve is opened to supply the film formation material filling the material-filled unit to the hearth liner via the communication path,
wherein the film formation device further comprises a weight measuring instrument that measures a weight of the film formation material supplied to the hearth liner.

3. The film formation device according to claim 2, wherein the weight measuring instrument measures the weight of the film formation material supplied to the hearth liner in a state in which inside of the film formation chamber is set to the film formation atmosphere.

4. The film formation device according to claim 2 or 3, wherein
the film formation chamber is provided with:
a first drive unit; and
a hearth holder that is rotatable by the first drive unit and concentrically supports a plurality of hearth liners,
the material supply chamber is provided with:
a second drive unit; and
a plurality of material-filled units that are revolvable by the second drive unit and are supported concentrically and each filled with the film formation material, and
the film formation device further comprises a controller that outputs control signals to the first drive unit and the second drive unit for controlling their rotation angles to match a position of one of the hearth liners in its revolving direction and a position of one of the material-filled units in its revolving direction with a position of the communication path.

5. The film formation device according to claim 2 or 3, wherein
the film formation chamber is provided with:
a first drive unit; and
a hearth holder that is rotatable by the first drive unit and concentrically supports a plurality of hearth liners,
the material-filled unit filled with the film formation material is provided at a position of the material supply chamber corresponding to a position of the communication path, and
the film formation device further comprises a controller that outputs a control signal to the first drive unit for controlling its rotation angle to match a position of one of the hearth liners in its revolving direction with a position of the material-filled unit in its revolving direction and a position of the communication path.

6. The film formation device according to claim 4 or 5, wherein the controller is configured to:
compare the weight of the film formation material measured by the weight measuring instrument with a reference weight range that is preliminarily set;
when the weight of the film formation material is within the reference weight range as a result of the comparison, continue a film formation process;
when the weight of the film formation material is below the reference weight range as a result of the comparison, further supply the film formation material to the hearth liner; and
when the weight of the film formation material is above the reference weight range as a result of the comparison, stop the film formation process and output a warning.

7. The film formation device according to claim 4 or 5, wherein
the hearth liner is supported by the hearth holder in a separable manner, and
a rotation shaft of the first drive unit is connected to the hearth holder.

8. The film formation device according to claim 7, wherein
the weight measuring instrument has a measurement unit and a measurement unit elevating mechanism,
the measurement unit elevating mechanism raises the hearth liner supported by the hearth holder, thereby separating the hearth liner from the hearth holder, and lowers the separated hearth liner thereby allowing the hearth liner to be supported on the hearth holder, and
the measurement unit is provided at a tip portion of the measurement unit elevating mechanism in contact with the hearth liner and measures a weight of the hearth liner in a state in which the hearth liner is separated from the hearth holder.

9. The film formation device according to claim 7 or 8, further comprising
a cooler that cools the hearth liner, wherein
the cooler has a cooler unit and a cooler unit elevating mechanism,
the cooler unit includes a cooling surface provided at a tip portion of the cooler unit elevating mechanism in contact with the hearth liner, and
the cooler unit elevating mechanism raises the hearth liner supported by the hearth holder to separate the hearth liner from the hearth holder, thereby bringing the cooling surface into contact with the hearth liner, and lowers the separated hearth liner to allow the hearth liner to be supported on the hearth holder, thereby releasing contact between the cooling surface and the hearth liner.

10. The film formation device according to claim 9, wherein
the cooler unit includes a coolant flow path provided inside the cooler unit elevating mechanism, a coolant that flows through the coolant flow path, a supply system that supplies the coolant to the coolant flow path, and a flow control valve provided in the coolant flow path,
the coolant flow path is not in contact with the hearth holder, and
the flow control valve controls a flow rate of the coolant.

11. The film formation device according to claim 9 or 10, further comprising
a temperature sensor that detects a temperature of the cooling surface or a temperature sensor that detects a temperature of the hearth liner.

12. The film formation device according to claim 11, wherein the controller is configured to:
compare the temperature detected by the temperature sensor with a reference temperature range that is preliminarily set;
when the detected temperature is within the reference temperature range as a result of the comparison, continue a film formation process;
when the detected temperature is below the reference temperature range as a result of the comparison, reduce a cooling capacity of the cooler, and
when the detected temperature is above the reference temperature range as a result of the comparison, increase the cooling capacity of the cooler.

13. The film formation device according to claim 12, wherein the controller is configured to:
when an output power value of the heating source is high, relatively increase the cooling capacity of the cooler compared to when the output power value is low.

14. The film formation device according to any one of claims 4 to 13, wherein the controller is configured to:
compare a film thickness of a film formed on the film formation target with a reference film thickness range that is preliminarily set;
when the film thickness of the film is above the reference film thickness range as a result of the comparison, reduce an amount of the film formation material supplied from the material supply chamber, and
when the film thickness of the film is below the reference film thickness range as a result of the comparison, increase the amount of the film formation material supplied from the material supply chamber.

15. The film formation device according to any one of claims 9 to 13, wherein the controller is configured to:
compare a film thickness of a film formed on the film formation target with a reference film thickness range that is preliminarily set;
when the film thickness of the film is above the reference film thickness range as a result of the comparison, reduce an amount of the film formation material supplied from the material supply chamber and reduce a cooling capacity of the cooler unit, and
when the film thickness of the film is below the reference film thickness range as a result of the comparison, increase the amount of the film formation material supplied from the material supply chamber and increase the cooling capacity of the cooler unit.

16. A film formation device comprising:
a film formation chamber in which at least a film formation material and a film formation target are provided, wherein the film formation chamber can be set to a predetermined film formation atmosphere;
a hearth liner provided inside the film formation chamber to accommodate the film formation material;
a heating source provided inside the film formation chamber to heat the film formation material accommodated in the hearth liner; and
a material supply chamber having a material-filled unit that is filled with the film formation material to supply to the hearth liner, wherein the material supply chamber is connected to the film formation chamber via a communication path having a gate valve and can be set to a predetermined pressure atmosphere,
wherein after inside of the material supply chamber is set to the predetermined pressure atmosphere in a state in which the film formation chamber is set to the film formation atmosphere, the gate valve is opened to supply the film formation material filling the material-filled unit to the hearth liner via the communication path,
wherein the material supply chamber is provided with a plurality of material-filled units, and at least two material-filled units are filled with different types of film formation materials.

17. A film formation device comprising:
a film formation chamber in which at least a film formation material and a film formation target are provided, wherein the film formation chamber can be set to a predetermined film formation atmosphere;
a hearth liner provided inside the film formation chamber to accommodate the film formation material;
a heating source provided inside the film formation chamber to heat the film formation material accommodated in the hearth liner; and
a material supply chamber having a material-filled unit that is filled with the film formation material to supply to the hearth liner, wherein the material supply chamber is connected to the film formation chamber via a communication path having a gate valve and can be set to a predetermined pressure atmosphere,
wherein after inside of the material supply chamber is set to the predetermined pressure atmosphere in a state in which the film formation chamber is set to the film formation atmosphere, the gate valve is opened to supply the film formation material filling the material-filled unit to the hearth liner via the communication path,
wherein the film formation chamber is provided with a plurality of hearth liners, and at least two hearth liners are supplied with different types of film formation materials.
